(19) Europäisches Patentamt
European Patent Office
Office européen des brevets

(11) **EP 3 329 540 B1**

(12) **EUROPÄISCHE PATENTSCHRIFT**

(45) Veröffentlichungstag und Bekanntmachung des Hinweises auf die Patenterteilung:
**05.06.2019 Patentblatt 2019/23**

(51) Int Cl.:
*H01M 10/48* (2006.01)   *G01R 31/36* (2019.01)
*G01R 19/165* (2006.01)   *G06F 17/18* (2006.01)

(21) Anmeldenummer: **16744691.3**

(22) Anmeldetag: **21.07.2016**

(86) Internationale Anmeldenummer:
**PCT/EP2016/067371**

(87) Internationale Veröffentlichungsnummer:
**WO 2017/016966 (02.02.2017 Gazette 2017/05)**

(54) **VERFAHREN UND VORRICHTUNG ZUM ABSCHÄTZEN EINES AKTUELLEN LEERLAUFSPANNUNGSVERLAUFS EINER BATTERIE**

METHOD AND APPARATUS FOR ESTIMATING AN INSTANTANEOUS OPEN-CIRCUIT VOLTAGE PROFILE OF A BATTERY

PROCÉDÉ ET DISPOSITIF D'ESTIMATION D'UNE COURBE ACTUELLE DE TENSION À VIDE D'UNE BATTERIE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **27.07.2015 DE 102015214128**

(43) Veröffentlichungstag der Anmeldung:
**06.06.2018 Patentblatt 2018/23**

(73) Patentinhaber: **Robert Bosch GmbH 70442 Stuttgart (DE)**

(72) Erfinder:
• **BECKER, Jens**
**67071 Ludwigshafen Am Rhein (DE)**
• **ZAFIRIDIS, Triantafyllos**
**74072 Heilbronn (DE)**
• **COIS, Olivier**
**71394 Kernen (DE)**
• **ERDEN, Michael**
**36179 Bebra (DE)**

(56) Entgegenhaltungen:
**DE-A1-102010 051 008    JP-A- 2012 137 330**

• **LIU GUANGMING ET AL: "Online estimation of lithium-ion battery remaining discharge capacity through differential voltage analysis", JOURNAL OF POWER SOURCES, ELSEVIER SA, CH, Bd. 274, 28. Oktober 2014 (2014-10-28), Seiten 971-989, XP029104412, ISSN: 0378-7753, DOI: 10.1016/J.JPOWSOUR.2014.10.132**

**EP 3 329 540 B1**

**Beschreibung**

Stand der Technik

Die vorliegende Erfindung betrifft ein Verfahren und eine Vorrichtung zum Abschätzen eines aktuellen Leerlaufspannungsverlaufs einer Batterie.

Aktuelle Batteriesysteme sind in der Lage, eine aktuelle Kapazität und einen aktuellen Gesundheitszustand einer zugehörigen Batterie zu ermitteln und bereitzustellen. Dazu ist es notwendig, einen zeitlichen Verlauf einer Batteriespannung und eines Batteriestromes der Batterie zu erfassen.

Aus dem zeitlichen Verlauf der Batteriespannung und einem Leerlaufspannungsverlauf der Batterie kann eine Ladungszustandsänderung der Batterie ermittelt werden. Aus dem zeitlichen Verlauf des Batteriestromes kann eine abgegebene oder aufgenommene Ladung der Batterie ermittelt werden, welche im Späteren als Ladungsänderung bezeichnet wird.

Aus der Ladungsänderung und der Ladungszustandsänderung kann auf eine aktuelle Kapazität der Batterie geschlossen werden. Aus der aktuellen Kapazität der Batterie und einer ursprünglichen Kapazität der Batterie kann auf den Gesundheitszustand der Batterie geschlossen werden.

Dabei stellt sich das Problem, dass für ein genaues Berechnen der Kapazität und des Gesundheitszustandes der Batterie die Ladungsänderung und die zugehörige Ladungszustandsänderung sehr groß sein müssen, um präzise Informationen zu erhalten. Dadurch ist für eine präzise Berechnung dieser Informationen ein fast vollständiger Lade- und Entladezyklus notwendig.

Zudem stellt sich das Problem, dass der Leerlaufspannungsverlauf der Batterie über deren Lebensdauer hinweg nicht konstant ist und es zu ungenauen Kapazitätsberechnungen aufgrund eines nicht mehr aktuellen Leerlaufspannungsverlaufs kommen kann, welcher der Berechnung zugrunde liegt.

JP2012-137330 offenbart ein Verfahren, in dem ein Leerlaufspannungsverlauf einer Batterie basierend auf einer Kennlinie eines Anodenpotentials und einer Kennlinie des Kathodenpotentials ermittelt wird.

DE 10 2010 051008 A1 offenbart ein Verfahren zum Abschätzen eines aktuellen Leerlaufspannungsverlaufs einer Batterie durch bestimmen alterungsabhängiger Punkte der OCV-Kennlinie und eines weiteren Punktes in der Umgebung des alterungsabhängigen Punkts, ermitteln der Steigung zwischen den 2 Punkten und anpassen der OCV-Kennlinie.

Offenbarung der Erfindung

Das erfindungsgemäße Verfahren zum Abschätzen eines aktuellen Leerlaufspannungsverlaufs einer Batterie umfasst ein Erfassen eines Abschnittes eines tatsächlichen Leerlaufspannungsverlaufes der Batterie, ein Detektieren oder Definieren eines signifikanten Punktes in dem erfassten Abschnitt des tatsächlichen Leerlaufspannungsverlauf, ein Erkennen eines dem signifikanten Punkt zugehörigen Punktes in einer Kennlinie eines Anodenpotentials der Batterie und/oder einer Kennlinie eines Kathodenpotentials der Batterie, ein Verschieben und/oder Skalieren der Kennlinie des Anodenpotentials und der Kennlinie des Kathodenpotentials basierend auf der Lage des signifikanten Punktes gegenüber dem zugehörigen Punkt, bis durch eine Kombination der verschobenen und/oder skalierten Kennlinien der erfasste Abschnitt nachgebildet wird, und ein Errechnen des aktuellen Leerlaufspannungsverlaufs basierend auf den verschobenen und/oder skalierten Kennlinien.

Auf diese Weise wird es ermöglicht, dass ein aktueller Leerlaufspannungsverlauf der Batterie abgeschätzt wird, ohne dass zuvor ein nahezu vollständiges Laden oder Entladen der Batterie erfolgt. Ferner wird es ermöglicht, den Leerlaufspannungsverlauf der Batterie kurzfristig zu aktualisieren und somit einer Änderung während der Lebensdauer der Batterie anzupassen. Bei einem Detektieren eines bestimmten Punktes wird ein Punkt basierend auf vorgegebenen Eigenschaften erkannt. Bei einem Definieren eines bestimmten Punktes wird ein beliebiger oder bestimmter Punkt als signifikanter Punkt ausgewählt.

Die erfindungsgemäße Vorrichtung ist dazu eingerichtet, das erfindungsgemäße Verfahren auszuführen und weist alle Vorteile des erfindungsgemäßen Verfahrens auf.

Die Unteransprüche zeigen bevorzugte Weiterbildungen der Erfindung.

Es ist vorteilhaft, wenn der Abschnitt des tatsächlichen Leerlaufspannungsverlaufs durch ein Erfassen einer Vielzahl von Messpunkten erfasst wird. Auf diese Weise kann der erste Leerlaufspannungsverlauf unter einem Aufwand minimaler Speicherkapazität bis zu seiner weiteren Verwendung vorgehalten werden.

Auch ist es vorteilhaft, wenn das Detektieren des signifikanten Punktes ein Interpolieren der erfassten Vielzahl von Messpunkten umfasst. Auf diese Weise kann eine Lage des signifikanten Punktes besonders genau bestimmt werden.

Ferner ist es vorteilhaft, wenn der signifikante Punkt ein Maximum oder ein Minimum in einer Steigung oder Krümmung des tatsächlichen Leerlaufspanungsverlaufes, oder ein Wendepunkt des tatsächlichen Leerlaufspannungsverlaufes ist. Ein solcher Punkt ist besonders charakteristisch und daher besonders zuverlässig in der Kennlinie des Anodenpotentials und in der Kennlinie des Kathodenpotentials wiederzufinden. Zudem kann ein solcher signifikanter Punkt auf mathematische Weise besonders einfach erkannt werden, wodurch ein notwendiger Rechenaufwand verringert wird.

Zudem ist es vorteilhaft, wenn das Verfahren ferner ein Bestimmen einer Batteriekapazität basierend auf dem aktuellen Leerlaufspannungsverlauf umfasst. Damit wird eine Schätzgenauigkeit bezüglich der Batteriekapazität signifikant erhöht.

Auch ist es vorteilhaft, wenn zunächst die Verschiebung und/oder Skalierung einer der beiden Kennlinien erfolgt und im Folgenden die andere der beiden Kennlinien in einem entsprechenden Ausmaß skaliert und/oder verschoben wird. Auf diese Weise wird ein für das Verfahren notwendiger Rechenaufwand minimiert.

Kurze Beschreibung der Zeichnungen

Nachfolgend werden Ausführungsbeispiele der Erfindung unter Bezugnahme auf die begleitende Zeichnung im Detail beschrieben. In der Zeichnung ist:

Figur 1    ein Diagramm, welches zwei beispielhafte Kennlinien eines Anodenpotentials und zwei beispielhafte Kennlinien eines Kathodenpotentials zeigt,

Figur 2    ein Diagramm, welches zwei beispielhafte Leerlaufspannungsverläufe zeigt,

Figur 3    ein Ablaufdiagramm des erfindungsgemäßen Verfahrens in einer ersten Ausführungsform, und

Figur 4    ein Diagramm, welches ein Verschieben und Skalieren einer Kennlinie des Anodenpotentials und einer Kennlinie des Kathodenpotentials gemäß einer Ausführungsform der Erfindung zeigt.

Ausführungsformen der Erfindung

Der vorliegenden Erfindung liegt das Prinzip zugrunde, dass jeder Leerlaufspannungsverlauf einer Batterie über eine zugehörige Kennlinie des Anodenpotentials der Batterie und eine zugehörige Kennlinie des Kathodenpotentials der Batterie berechnet werden kann. Dies gilt für jeden Alterungszustand der Batterie, also von deren Lebensanfang (BOL - Begin of life) bis zu deren Lebensende (EOL - End of life).

Eine Kennlinie des Anodenpotentials oder des Kathodenpotentials der Batterie wird auch als OCP bezeichnet. Ein Leerlaufspannungsverlauf der Batterie wird auch als OCV bezeichnet.

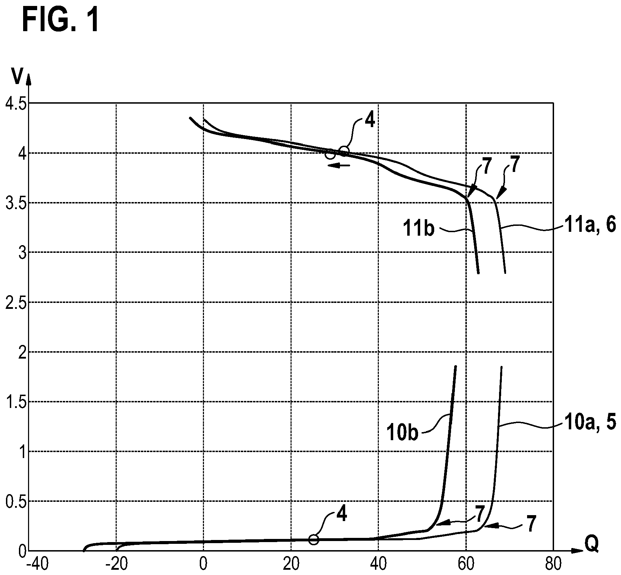

Figur 1 zeigt ein Diagramm, in welchem eine erste Kennlinie eines Anodenpotentials 10a, eine zweite Kennlinie eines Anodenpotentials 10b, eine erste Kennlinie eines Kathodenpotentials 11a und eine zweite Kennlinie eines Kathodenpotentials 11b dargestellt sind. Dabei beschreiben die erste Kennlinie des Anodenpotentials 10a und die erste Kennlinie des Kathodenpotentials 11a eine Batterie in einem ersten Alterungszustand. Die zweite Kennlinie des Anodenpotentials 10b und die zweite Kennlinie des Kathodenpotentials 11b beschreiben die Batterie in einem zweiten Alterungszustand.

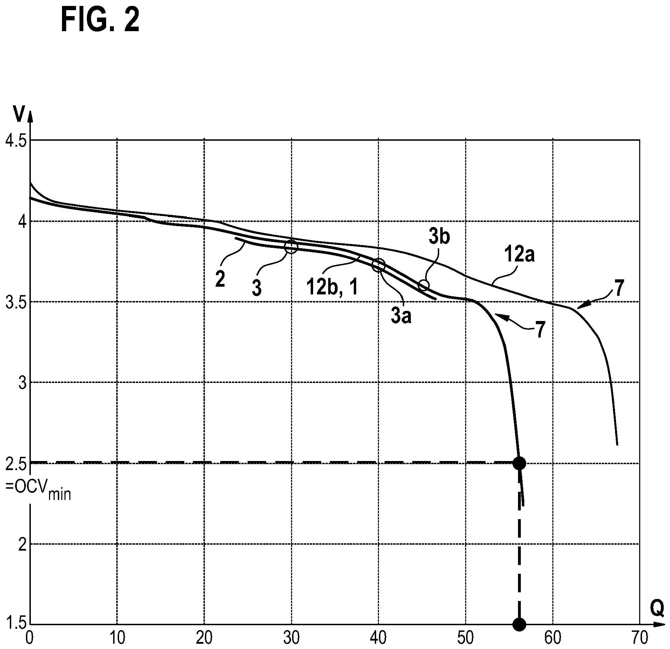

Figur 2 zeigt ein Diagramm, in welchem ein erster Leerlaufspannungsverlauf 12a und ein zweiter Leerlaufspannungsverlauf 12b dargestellt sind. Der erste Leerlaufspannungsverlauf 12a ist ein Leerlaufspannungsverlauf der Batterie in dem ersten Alterungszustand. Der zweite Leerlaufspannungsverlauf 12b ist ein Leerlaufspannungsverlauf der Batterie in dem zweiten Alterungszustand.

Aus der ersten Kennlinie des Anodenpotentials 10a und der ersten Kennlinie des Kathodenpotentials 11a kann der erste Leerlaufspannungsverlauf 12a ermittelt werden.

Mathematisch betrachtet ist die erste Kennlinie des Anodenpotentials 10a eine Funktion über einen Ladungszustand Q der Batterie. Der Ladungszustand Q ist in dem in Figur 2 dargestellten Diagramm auf der x-Achse angegeben. Der Ladungszustand ist dabei durch einen Wert beschrieben, der eine Ladungsmenge, beispielsweise in Amperestunden, beschreibt, welche von der Batterie ausgehend von einer maximalen Ladung abgegeben wurde. Somit ist die erste Kennlinie des Anodenpotentials 10a durch eine Funktion $f_{an}(Q)$ beschrieben. Selbiges gilt für die erste Kennlinie des Kathodenpotentials 11a, welche somit durch eine Funktion $f_{cat}(Q)$ beschrieben ist.

Um den ersten Leerlaufspannungsverlauf 12a aus der ersten Kennlinie des Anodenpotentials 10a und der ersten Kennlinie des Kathodenpotentials 11a zu ermitteln, wird das Anodenpotential von dem Kathodenpotential subtrahiert. Es gilt somit:

$$OCV_1(Q) = f_{cat}(Q) - f_{an}(Q)$$

Dabei repräsentiert $OCV_1(Q)$ eine Funktion welche den ersten Leerlaufspannungsverlauf 12a beschreibt.

Mit Hinsicht auf Figur 1 ist ersichtlich, dass die erste Kennlinie des Anodenpotentials 10a und die zweite Kennlinie des Anodenpotentials 10b in ihrem Verlauf ähnlich sind und dass die erste Kennlinie des Anodenpotentials 10a durch ein Skalieren und Verschieben in die zweite Kennlinie des Anodenpotentials 10b überführt werden kann. Somit kann die zweite Kennlinie des Anodenpotentials 10b durch eine Funktion $f_{an}(\alpha_{an} Q + \beta_{an})$ beschrieben werden, welche einer verschobenen und skalierten Funktion $f_{an}(Q)$ entspricht. Dabei ist der Faktor $\alpha_{an}$ ein Faktor für die Skalierung und der Faktor $\beta_{an}$ ein Faktor für die Verschiebung der zweiten Kennlinie des Anodenpotentials 10b gegenüber der ersten Kennlinie des Anodenpotentials 10a.

In entsprechender Weise kann die erste Kennlinie des Kathodenpotentials 11a in die zweite Kennlinie des Kathodenpotentials 11b durch Skalieren und Verschieben überführt werden. Somit kann die zweite Kennlinie des Kathodenpotentials 11b durch eine Funktion $f_{cat}(\alpha_{cat} Q + \beta_{cat})$ beschrieben werden, welche einer verschobenen und skalierten Funktion $f_{cat}(Q)$ entspricht. Dabei ist der Faktor $\alpha_{cat}$ ein Faktor für die Skalierung und der Faktor $\beta_{cat}$ ein Faktor für die Verschiebung der zweiten Kennlinie des Kathodenpotentials 11b gegenüber der ersten Kennlinie des Kathodenpotentials 11a.

Da der zweite Leerlaufspannungsverlauf 12b aus der zweiten Kennlinie des Anodenpotentials 10b und der zweiten Kennlinie des Kathodenpotentials 11b ermittelt werden kann, gilt somit:

$$OCV_2(Q) = f_{cat}(\alpha_{cat} Q + \beta_{cat}) - f_{an}(\alpha_{an} Q + \beta_{an})$$

Dabei repräsentiert $OCV_2(Q)$ eine Funktion welche den zweiten Leerlaufspannungsverlauf 12b beschreibt.

Erfindungsgemäß wird basierend auf den zuvor beschriebenen Prinzipien ein aktueller Leerlaufspannungsverlauf einer Batterie, welcher beispielsweise nach einer gewissen Alterung der Batterie auftritt, mit Hilfe von Skalierung und Verschiebung einer Kennlinie des Anodenpotentials der Batterie und einer Kennlinie des Kathodenpotentials der Batterie ermittelt.

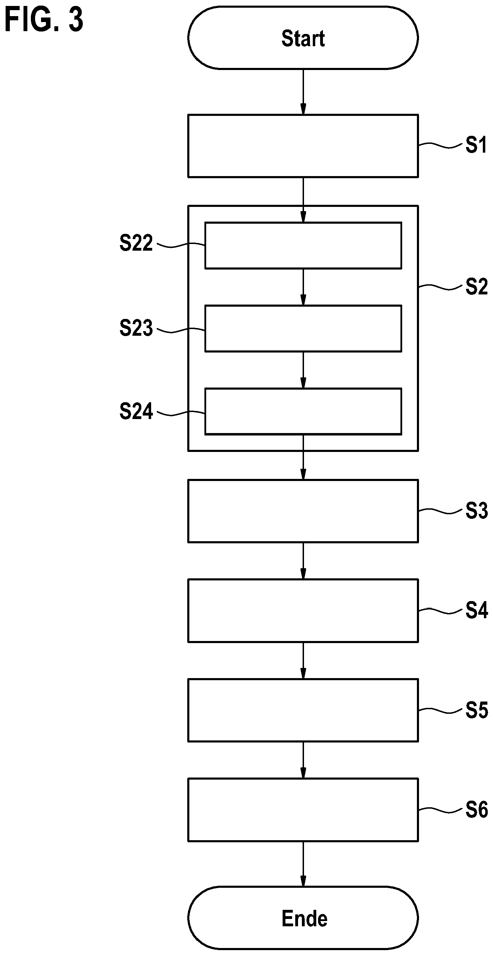

Figur 3 zeigt ein Ablaufdiagramm eines erfindungsgemäßen Verfahrens in einer ersten Ausführungsform. Bei einem Start des Verfahrens wird zunächst ein erster Schritt S1 ausgeführt.

In dem ersten Schritt S1 erfolgt ein Erfassen eines Abschnitts 2 eines tatsächlichen Leerlaufspannungsverlaufes 1 der Batterie. Der tatsächliche Leerlaufspannungsverlauf 1 ist ein Leerlaufspannungsverlauf, den die Batterie zu dem Zeitpunkt, an dem das erfindungsgemäße Verfahren ausgeführt wird, tatsächlich aufweist. Eine Spannung der Batterie und ein von der Batterie abgegebener oder aufgenommener Strom wird gemessen. Aus diesen Werten wird eine Ladungszustandsänderung der Batterie errechnet und für mehrere Ladungszustände innerhalb dieser Ladungszustandsänderung jeweils ein zugehöriger Spannungswert gespeichert. Jeder Spannungswert repräsentiert einen Messpunkt. Somit wird der Abschnitt 2 des tatsächlichen Leerlaufspannungsverlaufs 1 durch ein Erfassen einer Vielzahl von Messpunkten erfasst.

Der bei dem Erfassen des Abschnittes 2 des tatsächlichen Leerlaufspannungsverlaufes 1 erfasste Abschnitt 2 entspricht ungefähr einem zugehörigen Abschnitt des aktuellen Leerlaufspannungsverlaufs der Batterie. Da jedoch nur ein Abschnitt des tatsächlichen Leerlaufspannungsverlaufes erfasst wurde, wird im weiteren Verfahren ein kompletter Leerlaufspannungsverlauf ermittelt, um den aktuellen Leerlaufspannungsverlauf der Batterie abzuschätzen.

Nach dem ersten Schritt S1 wird ein zweiter Schritt S2 ausgeführt. Darin erfolgt ein Detektieren eines signifikanten Punktes 3 in dem erfassten Abschnitt 2 des tatsächlichen Leerlaufspannungsverlaufs. Der zweite Schritt S2 ist in einen ersten Unterschritt S21, einen zweiten Unterschritt S22 und einen dritten Unterschritt S23 unterteilt.

Zunächst wird der erste Unterschritt S21 ausgeführt. In dem ersten Unterschritt S21 erfolgt ein Interpolieren der erfassten Vielzahl von Messpunkten. Darin werden die zwischen den erfassten Messpunkten liegenden Spannungswerte interpoliert, um den Abschnitt 2 des tatsächlichen Leerlaufspannungsverlaufes der Batterie in Form einer kontinuierlichen Kurve zu erhalten.

In dem Folgenden zweiten Unterschritt S22 wird eine erste Ableitung und eine zweite Ableitung für den erfassten Abschnitt 2 des tatsächlichen Leerlaufspannungsverlaufes errechnet.

In dem Folgenden dritten Unterschritt S23 wird der signifikante Punkt 3 basierend auf den für den Abschnitt 2 berechneten Ableitungen des tatsächlichen Leerlaufspannungsverlaufes ermittelt und somit detektiert.

Figur 2 zeigt beispielhaft einen erfassten Abschnitt 2 des tatsächlichen Leerlaufspannungsverlaufes der Batterie. Es sei dabei angenommen, dass der zweite Leerlaufspannungsverlauf 12b einem tatsächlichen Leerlaufspannungsverlauf der Batterie entspricht. Ein Abschnitt 2 dieses tatsächlichen Leerlaufspannungsverlaufes wurde in dem ersten Schritt S1 erfasst. Durch die in dem zweiten Schritt S2 ermittelten Ableitungen wird der signifikante Punkt 3 ermittelt, welcher sich in dem in Figur 2 gezeigten Beispiel dadurch auszeichnet, dass ein Wendepunkt in dem tatsächlichen Leerlaufspannungsverlauf 2 auftritt. Dieser tritt in etwa bei einem Ladungszustand Q der Batterie auf, der mit dem Wert "30" beschrieben ist. Ein solcher Wendepunkt kann beispielsweise durch eine Nullstelle der zweiten Ableitung erkannt werden.

Anstelle eines Wendepunktes, welcher hier beispielhaft als signifikanter Punkt 3 gewählt wurde, sind insbesondere lokale Maxima oder lokale Minima in einer Steigung oder Krümmung des zweiten Leerlaufspanungsverlaufes 12b, in dem erfassten Abschnitt 2 zur Auswahl als signifikanter Punkt 3 geeignet. Erfindungsgemäß kann ein signifikanter Punkt 3 auch durch die Eigenschaften mehrerer aneinander angrenzender Punkte, also einen Kurvenverlauf, definiert sein.

Als alternativer signifikanter Punkt ist in Figur 2 ein Maximum 3a in einer Krümmung des zweiten Leerlaufspanungsverlaufes 12b gezeigt, welches beispielsweise aus einem Maximum der ersten Ableitung des erfassten Abschnittes 2 des tatsächlichen Leerlaufspannungsverlaufes ermittelt werden kann. Als weiterer alternativer signifikanter Punkt ist in Figur 2 ein lokales Maximum 3b in einer Steigung des zweiten Leerlaufspanungsverlaufes 12b gezeigt, welches beispielsweise aus einem Maximum der ersten Ableitung des erfassten Abschnittes 2 des zweiten Leerlaufspannungsverlaufes 12b ermittelt werden kann. Es können auch unterschiedliche signifikante Punkte gewählt werden, um einen zugehörigen Punkt in der Kennlinie des Anodenpotentials und in der Kennlinie des Anodenpotentials basierend auf unterschiedlichen signifikanten Punkten zu erkennen. Auch eine Definition oder ein Erkennen mehrerer signifikanter Punkte ist vorteilhaft.

In alternativen Ausführungsformen der Erfindung wird ein beliebiger Punkt des erfassten Abschnittes 2 des zweiten Leerlaufspannungsverlaufs 1 als signifikanter Punkt 3 definiert. Der zugehörige Punkt 4 kann dabei beispielsweise anhand eines Kurvenverlaufs im Bereich des signifikanten Punktes 3 und im Bereich des zugehörigen Punktes erkannt werden.

In Anschluss an den zweiten Schritt S2 wird ein dritter Schritt S3 ausgeführt. Darin erfolgt ein Erkennen eines dem signifikanten Punkt 3 zugehörigen Punktes 4 in einer Kennlinie eines Anodenpotentials 5 der Batterie und einer Kennlinie eines Kathodenpotentials 6 der Batterie. Die Kennlinie des Anodenpotentials 5 und die Kennlinie des Kathodenpotentials 6 sind in dieser Ausführungsform Kennlinien, welche einmalig bei einer Herstellung der Batterie gemessen und gespeichert wurden. Es sei angenommen, dass die Kennlinie des Anodenpotentials 5 der in Figur 1 gezeigten ersten Kennlinie des Anodenpotentials 10a entspricht und die Kennlinie des Kathodenpotentials 6 der in Figur 1 gezeigten ersten Kennlinie des Kathodenpotentials 11a entspricht.

Wie zuvor beschrieben ist der signifikante Punkt 3 in dieser ersten Ausführungsform ein Wendepunkt in dem tatsächlichen Leerlaufspannungsverlauf. Daher wird in dieser ersten Ausführungsform in dem dritten Schritt S3 ebenfalls ein Wendepunkt in der Kennlinie des Anodenpotentials 5 und der Kennlinie des Kathodenpotentials 6 gesucht und erkannt. Dabei kann eine Suche auf einen vorgegebenen Bereich der Kennlinie des Anodenpotentials 5 und der Kennlinie des Kathodenpotentials 6 beschränkt werden, um eine Unterscheidung im Falle mehrerer Wendepunkte in diesen Kennlinien zu ermöglichen. Es ist in Figur 1 ersichtlich, dass diese Kennlinien einen zugehörigen Wendepunkt aufweisen. Der zugehörige Punkt 4 in den Kennlinien des Anodenpotentials und des Kathodenpotentials ist somit der zugehörige Wendepunkt, welcher ebenfalls in diesen Kennlinien 5, 6 auftaucht. Da die Wendepunkte in den Figuren 1 und 2 aufgrund des flachen Kurvenverlaufes nur schwer zu erkennen sind wird darauf verwiesen, dass der erfasste Abschnitt 2 des tatsächlichen Leerlaufspannungsverlaufes sich auch über den in allen Kennlinien auftretenden Knick 7 erstrecken könnte. Es ist nunmehr leicht ersichtlich, dass dieser Knick 7 in allen beschriebenen Kennlinien auftritt und widererkannt werden kann.

Nach dem Ausführen des dritten Schrittes S3 wird ein vierter Schritt S4 ausgeführt. In dem vierten Schritt S4 erfolgt ein Verschieben und/oder Skalieren der Kennlinie des Anodenpotentials 5 und/oder der Kennlinie des Kathodenpotentials 6 basierend auf der Lage des signifikanten Punktes 3 gegenüber dem zugehörigen Punkt 4, bis durch eine Kombination der verschobenen Kennlinien 5, 6 der erfasste Abschnitt 2 bestmöglich nachgebildet wird.

Dazu werden in dieser Ausführungsform die Kennlinie des Anodenpotentials 5 und die Kennlinie des Kathodenpotentials 6 zunächst derart verschoben und skaliert, dass der zugehörige Punkt 4 der Kennlinie des Anodenpotentials 5 und der zugehörige Punkt 4 der Kennlinie des Kathodenpotentials 6 so verschoben werden, dass diese auf den Ladungszustand fallen, der dem signifikanten Punkt 3 zugehörig ist. Dann wird aus den derart verschobenen und skalierten Kennlinien ein zugehöriger temporärer Leerlaufspannungsverlauf für den Abschnitt 2 ermittelt. Es wird eine quadratische Abweichung zwischen dem Abschnitt 2 des tatsächlichen Leerlaufspannungsverlaufs und einem zugehörigen Abschnitt des temporären Leerlaufspannungsverlaufs ermittelt. Die so ermittelte Abweichung wird durch eine Anpassung der Verschiebung und der Skalierung der Kennlinie des Anodenpotentials 5 und der Kennlinie des Kathodenpotentials 6 minimiert. Da die Verschiebung und der Skalierung der Kennlinie des Anodenpotentials 5 und der Kennlinie des Kathodenpotentials 6 von zugehörigen Verschiebungsfaktoren und die Skalierungsfaktoren abhängt, welche zuvor beispielhaft durch die Faktoren $\alpha_{an}$, $\alpha_{cat}$, $\beta_{an}$ und $\beta_{an}$ gebildet wurden, wird in diesem vierten Schritt also für jeden dieser Faktoren ein Wert ermittelt.

Nach dem Ausführen des vierten Schrittes S4 wird ein fünfter Schritt S5 ausgeführt. Darin erfolgt ein Errechnen des aktuellen Leerlaufspannungsverlaufs basierend auf den verschobenen und/oder skalierten Kennlinien. Dies erfolgt basierend auf dem der Erfindung zugrundeliegenden Zusammenhang, welcher bereits mit Hinblick auf den zweiten Leerlaufspannungsverlauf $OCV_2(Q)$ beschrieben wurde. In entsprechender Weise ergibt sich für den aktuellen Leerlaufspannungsverlauf, welcher durch die Funktion $OCV_{act}(Q)$ beschrieben wird:

$$OCV_{act}(Q) = f_{cat}(\alpha_{cat}Q + \beta_{cat}) - f_{an}(\alpha_{an}Q + \beta_{an})$$

Die zugrundeliegenden Funktionen $f_{cat}(Q)$ und $f_{an}(Q)$ beschreiben die bei der Herstellung der Batterie gespeicherte Kennlinie des Anodenpotentials 5 und die bei der Herstellung der Batterie gespeicherte Kennlinie des Kathodenpotentials 6. Der so errechnete aktuelle Leerlaufspannungsverlaufs ist ein abgeschätzter aktueller Leerlaufspannungsverlauf.

Nach dem Ausführen des fünften Schrittes S5 wird ein sechster Schritt S6 ausgeführt. Darin erfolgt ein Bestimmen einer Batteriekapazität basierend auf dem aktuellen Leerlaufspannungsverlauf. Dazu wird ein zugehöriger Ladungszustand Q der Batterie in dem ermittelten aktuellen Leerlaufspannungsverlauf ermittelt, welcher einer vordefinierten minimalen Batteriespannung zugehörig ist. Dieser zugehörige Ladungszustand Q der Batterie beschreibt die Batteriekapazität der Batterie.

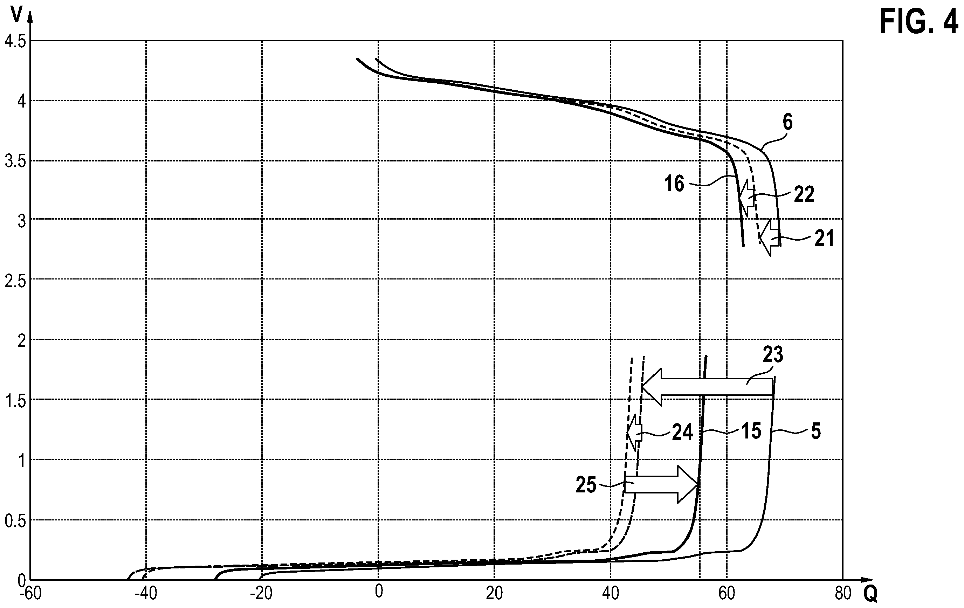

Figur 4 zeigt ein beispielhaftes Verschieben und Skalieren der Kennlinien des Anodenpotentials und des Kathodenpotentials in einer bevorzugten Ausführungsform der Erfindung.

Zunächst wird die Kennlinie des Kathodenpotentials 6 skaliert, was mit einem ersten Pfeil 21 dargestellt ist. Dann wird die Kennlinie des Kathodenpotentials 6 verschoben, was durch einen zweiten Pfeil 22 dargestellt ist. Dabei wird die Kennlinie des Kathodenpotentials 6 derart verschoben, dass das durch diese Kennlinie beschriebene Potential einer Anode der Batterie bei vollständiger Ladung der Batterie erhalten bleibt. Durch das Skalieren der Kennlinie des Kathodenpotentials 6 wird somit der Faktor $\alpha_{cat}$ zumindest vorläufig ermittelt. Durch das Verschieben der Kennlinie des Kathodenpotentials 6 wird somit der Faktor $\beta_{cat}$ zumindest vorläufig ermittelt.

Es gilt somit für die Kennlinie des Kathodenpotentials 6, welche im Folgenden auch als $OCP_{cat}$ bezeichnet wird:

$$OCP_{cat} = f_{cat}(Q \cdot \gamma - \delta)$$

Dabei steht y für den ermittelten Wert des Faktors $\alpha_{cat}$ und somit für die mit dem ersten Pfeil 21 dargestellte Skalierung. Ferner steht $\delta$ für den ermittelten Wert des Faktors $\beta_{cat}$ und somit für die mit dem zweiten Pfeil 22 dargestellte Verschiebung.

Im Folgenden wird die Kennlinie des Anodenpotentials 5 skaliert und Verschoben. Die Kennlinie des Anodenpotentials 5 wird im Folgenden auch als $OCP_{an}$ bezeichnet. Das Verschieben und Skalieren des Anodenpotentials 5 erfolgt basierend auf der folgenden Gleichung:

$$OCP_{an} = f_{an}([Q - pBOL] \cdot \gamma + pACT)$$

Dabei ist der Wert pBOL der Ladungszustand, an dem der signifikante Punkt 3 in dem Leerlaufspannungsverlauf der Batterie auftritt, wenn die Batterie noch am Anfang ihres Lebenszyklus steht (Begin of Life). Der Wert pACT ist der Ladungszustand an dem der signifikante Punkt 3 in dem tatsächlichen Leerlaufspannungsverlauf der Batterie auftritt. In Figur 4 ist eine gewichtete Verschiebung, die sich aus dem Term [Q - pBOL] ergibt mit einem dritten Pfeil 23 dargestellt. Eine Skalierung mit dem Faktor y ist mit einem vierten Pfeil 24 dargestellt. Eine Verschiebung um den Wert pACT ist mit einem fünften Pfeil 25 dargestellt.

Es ist ersichtlich, dass bei dem anhand der Figur 4 beschriebenen Beispiel eine Verschiebung der Kennlinien fest vorgegeben ist. Lediglich ein einzelner Skalierungsfaktor y, von dem sowohl die Kennlinie des Anodenpotentials 5 als auch die Kennlinie des Kathodenpotentials 6 abhängt, wird variiert, um die Abweichung zwischen dem Abschnitt 2 des tatsächlichen Leerlaufspannungsverlaufs 2 und dem zugehörigen Abschnitt des temporären Leerlaufspannungsverlaufs zu minimieren.

In weiteren alternativen Ausführungsformen wird eine aktuelle Kapazität der Batterie aus den Ladungszuständen der Anode $Q^+$ und der Kathode $Q^-$ ermittelt. Das Verfahren entspricht der ersten Ausführungsform, jedoch werden die Kennlinie des Anodenpotentials und die Kennlinie des Kathodenpotentials unabhängig betrachtet. Das bedeutet, dass die Kathode und die Anode einen unterschiedlichen Ladungszustand aufweisen können.

Wie bereits beschrieben kann die Leerlaufspannung einer Batterie, insbesondere einer Batteriezelle, aus den Kennlinien des Anodenpotentials und des Kathodenpotentials ermittelt werden.

Es gilt somit:

$$OCV_{cell} = OCP^+ (SOC^+) - OCP^-(SOC^-)$$

Dabei ist $OCV_{cell}$ die Leerlaufspannung der Batterie. $OCP^+ (SOC^+)$ ist die Kennlinie des Kathodenpotentials abhängig von einem kathodenseitigen Ladungsgrad $SOC^+$ der Batterie (SOC = state of Charge). $OCP^- (SOC^-)$ ist die Kennlinie des Anodenpotentials abhängig von einem anodenseitigen Ladungsgrad $SOC^-$ der Batterie. Der Ladungsgrad der Batterie ist ein Verhältnis zwischen Ladungszustand Q der Batterie und Kapazität C der Batterie. Somit gilt:

$$OCV_{cell} = OCP^+ (Q^+ / C^+) - OCP^- (Q^- / C^-)$$

Die kathodenseitige Kapazität $C^+$ der Batterie ergibt sich aus einer kathodenseitigen Kapazität der Batterie zu deren Lebensanfang und einem Gesundheitszustand der Kathode. Die anodenseitige Kapazität $C^-$ der Batterie ergibt sich aus der anodenseitigen Kapazität der Batterie zu deren Lebensanfang und einem Gesundheitszustand der Anode.

Dabei kann auch ein Verhältnis zwischen einer Alterung der Anode und einer Alterung der Kathode berücksichtigt werden. Durch eine getrennte Betrachtung der kathodenseitigen und anodenseitigen Kapazität $C^+$ und $C^-$ kann eine Alterung der Batterie besonders genau nachgebildet werden.

Die maximale Kapazität der Batterie zu einem gewissen Alterungszustand lässt sich aus den Ladungszuständen der Anode $Q^+$ und der Kathode $Q^-$ ermitteln. Dabei werden die noch erreichbaren maximalen Ladungszuständen der Anode und Kathode ermittelt. Die maximalen noch erreichbaren Ladungszustände werden basierend auf einem Entladungsgrad der Batterie ermittelt. Dieser Entladungsgrad wird basierend auf dem signifikanten Punkt 3 ermittelt. Dies kann beispielsweise erfolgen, indem die Lage des signifikanten Punkt 3 in dem tatsächlichen Leerlaufspannungsverlauf 1 mit dessen Lage in einem Leerlaufspannungsverlauf zu deren Lebensanfang (BOL) verglichen wird.

Bei allen Ausführungsformen des erfindungsgemäßen Verfahrens wird eine besonders hohe Genauigkeit bei dem Abschätzen des aktuellen Leerlaufspannungsverlaufes erreicht, wenn ein zugehöriger Punkt 4 in einer Kennlinie des Anodenpotentials 5 der Batterie und zudem ein zugehöriger Punkt 4 in einer Kennlinie des Kathodenpotentials 6 der Batterie ermittelt wird und die Kennlinien jeweils basierend auf einer Lage des jeweils zugehörigen Punktes 4 verschoben und/oder skaliert werden. Dennoch ist es erfindungsgemäß ausreichend, wenn lediglich ein zugehöriger Punkt 4, also entweder in der Kennlinie des Anodenpotentials 5 oder in der Kennlinie des Kathodenpotentials 6 der Batterie, ermittelt wird und eine oder beide der Kennlinien basierend auf der Lage des signifikanten Punktes 3 gegenüber dem einen zugehörigen Punkt 4 verschoben werden. Dem liegt das Prinzip zugrunde, dass eine notwendige Skalierung und Verschiebung der Kennlinien zumindest ähnlich ist.

Ebenso wird eine besonders hohe Genauigkeit bei dem Abschätzen des aktuellen Leerlaufspannungsverlaufes erreicht, wenn sowohl ein Skalieren als auch ein Verschieben der Kennlinien erfolgt. Dennoch ist es erfindungsgemäß ausreichend, wenn lediglich ein Skalieren oder lediglich ein Verschieben der Kennlinien erfolgt. Auf diese Weise kann eine notwendige Rechenleistung zur Durchführung des erfindungsgemäßen Verfahrens erheblich verringert werden.

Neben der obigen schriftlichen Offenbarung wird explizit auf die Offenbarung der Figuren 1 bis 4 verwiesen.

**Patentansprüche**

1.  Verfahren zum Abschätzen eines aktuellen Leerlaufspannungsverlaufs einer Batterie, umfassend:

    - ein Erfassen eines Abschnittes (2) eines tatsächlichen Leerlaufspanungsverlaufes (1) der Batterie,
    - ein Detektieren oder Definieren eines signifikanten Punktes (3) in dem erfassten Abschnitt (2) des tatsächlichen Leerlaufspannungsverlaufs (1),
    - ein Erkennen eines dem signifikanten Punkt (3) zugehörigen Punktes (4) in einer Kennlinie eines Anodenpotentials (5) der Batterie und/oder in einer Kennlinie eines Kathodenpotentials (6) der Batterie,
    - ein Verschieben und/oder Skalieren der Kennlinie des Anodenpotentials (5) und der Kennlinie des Kathodenpotentials (6) basierend auf der Lage des signifikanten Punktes (3) gegenüber dem zugehörigen Punkt (4), bis durch eine Kombination der verschobenen und/oder skalierten Kennlinien (5, 6) der erfasste Abschnitt (2) nachgebildet wird,
    - ein Errechnen des aktuellen Leerlaufspannungsverlaufs basierend auf den verschobenen und/oder skalierten Kennlinien.

**2.** Verfahren gemäß Anspruch 1, **dadurch gekennzeichnet, dass** der Abschnitt (2) des tatsächlichen Leerlaufspannungsverlaufs (1) durch ein Erfassen einer Vielzahl von Messpunkten erfasst wird.

**3.** Verfahren gemäß Anspruch 2, **dadurch gekennzeichnet, dass** das Detektieren des signifikanten Punktes (3) ein Interpolieren der erfassten Vielzahl von Messpunkten umfasst.

**4.** Verfahren gemäß einem der vorhergehenden Ansprüche, **dadurch gekennzeichnet, dass** der signifikante Punkt (3) ein Maximum oder ein Minimum in einer Steigung oder Krümmung des tatsächlichen Leerlaufspanungsverlaufes (1), oder ein Wendepunkt des tatsächlichen Leerlaufspanungsverlaufes (1) ist.

**5.** Verfahren gemäß einem der vorhergehenden Ansprüche, ferner umfassend ein Bestimmen einer Batteriekapazität basierend auf dem aktuellen Leerlaufspannungsverlauf.

**6.** Verfahren gemäß einem der vorhergehenden Ansprüche, **dadurch gekennzeichnet, dass** zunächst die Verschiebung und/oder Skalierung einer der beiden Kennlinien (5, 6) erfolgt und im Folgenden die andere der beiden Kennlinien (5, 6) in einem entsprechenden Ausmaß skaliert und/oder verschoben wird.

**7.** Vorrichtung, die dazu eingerichtet ist, das Verfahren gemäß einem der vorhergehenden Ansprüche auszuführen.

**Claims**

**1.** Method for estimating a current open-circuit voltage profile of a battery, comprising:

- acquiring a section (2) of an actual open-circuit voltage profile (1) of the battery,
- detecting or defining a significant point (3) in the acquired section (2) of the actual open-circuit voltage profile (1),
- recognizing a point (4), associated with the significant point (3), in a characteristic curve of an anode potential (5) of the battery and/or in a characteristic curve of a cathode potential (6) of the battery,
- shifting and/or scaling the characteristic curve of the anode potential (5) and the characteristic curve of the cathode potential (6) on the basis of the position of the significant point (3) in relation to the associated point (4), until the acquired section (2) is replicated through a combination of the shifted and/or scaled characteristic curves (5, 6),
- calculating the current open-circuit voltage profile on the basis of the shifted and/or scaled characteristic curves.

**2.** Method according to Claim 1, **characterized in that** the section (2) of the actual open-circuit voltage profile (1) is acquired by acquiring a multiplicity of measurement points.

**3.** Method according to Claim 2, **characterized in that** detecting the significant point (3) comprises interpolating the acquired multiplicity of measurement points.

**4.** Method according to one of the preceding claims, **characterized in that** the significant point (3) is a maximum or a minimum in a gradient or curvature of the actual open-circuit voltage profile (1), or is a point of inflection of the actual open-circuit voltage profile (1) .

**5.** Method according to one of the preceding claims, furthermore comprising determining a battery capacity on the basis of the current open-circuit voltage profile.

**6.** Method according to one of the preceding claims, **characterized in that** one of the two characteristic curves (5, 6) is first of all shifted and/or scaled and the other of the two characteristic curves (5, 6) is subsequently scaled and/or shifted to a corresponding degree.

**7.** Device configured so as to execute the method according to one of the preceding claims.

**Revendications**

**1.** Procédé pour estimer une courbe de tension à vide actuelle d'une batterie, comprenant :

- une acquisition d'une portion (2) d'une courbe de tension à vide (1) réelle de la batterie,
- une détection ou une définition d'un point remarquable (3) dans la portion (2) acquise de la courbe de tension à vide (1) réelle,
- une reconnaissance d'un point (4) associé au point remarquable (3) dans une courbe caractéristique d'un potentiel d'anode (5) de la batterie et/ou dans une courbe caractéristique d'un potentiel de cathode (6) de la batterie,
- un décalage et/ou une mise à l'échelle de la courbe caractéristique du potentiel d'anode (5) et de la courbe caractéristique du potentiel de cathode (6) en se basant sur la position du point remarquable (3) par rapport au moins associé (4) jusqu'à reproduire la portion (2) acquise par une combinaison des courbes caractéristiques (5, 6) décalées et/ou mises à l'échelle,
- un calcul de la courbe de tension à vide actuelle en se basant sur les courbes caractéristiques décalées et/ou mises à l'échelle.

2. Procédé selon la revendication 1, **caractérisé en ce que** la portion (2) de la courbe de tension à vide (1) réelle est acquise par une acquisition d'une pluralité de points de mesure.

3. Procédé selon la revendication 2, **caractérisé en ce que** la détection du point remarquable (3) comprend une interpolation de la pluralité de points de mesure acquis.

4. Procédé selon l'une des revendications précédentes, **caractérisé en ce que** le point remarquable (3) est un maximum ou un minimum dans une pente ou une courbure de la courbe de tension à vide (1) réelle, ou un point d'inflexion de la courbe de tension à vide (1) réelle.

5. Procédé selon l'une des revendications précédentes, comprenant en outre la détermination d'une capacité de batterie en se basant sur la courbe de tension à vide actuelle.

6. Procédé selon l'une des revendications précédentes, **caractérisé en ce que** le décalage et/ou la mise à l'échelle de l'une des deux courbes caractéristiques (5, 6) est tout d'abord effectué et ensuite l'autre des deux courbes caractéristiques (5, 6) est mise à l'échelle et/ou décalée dans une mesure correspondante.

7. Dispositif qui est conçu pour mettre en oeuvre le procédé selon l'une des revendications précédentes.

FIG. 1

# FIG. 2

## FIG. 3

```
            ┌─────────────┐
            │    Start     │
            └─────────────┘
                   │
                   ▼
        ┌─────────────────────┐
        │                     │──── S1
        └─────────────────────┘
                   │
                   ▼
        ┌─────────────────────────┐
        │  ┌───────────────────┐  │
   S22 ─┤  │                   │  │
        │  └───────────────────┘  │
        │          │              │──── S2
        │          ▼              │
        │  ┌───────────────────┐  │
   S23 ─┤  │                   │  │
        │  └───────────────────┘  │
        │          │              │
        │          ▼              │
        │  ┌───────────────────┐  │
   S24 ─┤  │                   │  │
        │  └───────────────────┘  │
        └─────────────────────────┘
                   │
                   ▼
        ┌─────────────────────┐
        │                     │──── S3
        └─────────────────────┘
                   │
                   ▼
        ┌─────────────────────┐
        │                     │──── S4
        └─────────────────────┘
                   │
                   ▼
        ┌─────────────────────┐
        │                     │──── S5
        └─────────────────────┘
                   │
                   ▼
        ┌─────────────────────┐
        │                     │──── S6
        └─────────────────────┘
                   │
                   ▼
            ┌─────────────┐
            │    Ende      │
            └─────────────┘
```

FIG. 4

**IN DER BESCHREIBUNG AUFGEFÜHRTE DOKUMENTE**

**In der Beschreibung aufgeführte Patentdokumente**

- JP 2012137330 A
- DE 102010051008 A1